(19) Europäisches Patentamt
European Patent Office
Office européen des brevets

(11) **EP 3 047 291 B1**

(12) # EUROPÄISCHE PATENTSCHRIFT

(45) Veröffentlichungstag und Bekanntmachung des Hinweises auf die Patenterteilung:
**17.05.2017 Patentblatt 2017/20**

(21) Anmeldenummer: **14766425.4**

(22) Anmeldetag: **09.09.2014**

(51) Int Cl.:
*G01R 31/42* (2006.01)   *G01R 19/25* (2006.01)
*G01R 31/34* (2006.01)

(86) Internationale Anmeldenummer:
**PCT/EP2014/069182**

(87) Internationale Veröffentlichungsnummer:
**WO 2015/039925 (26.03.2015 Gazette 2015/12)**

(54) **VERFAHREN UND ANORDNUNG ZUM ERMITTELN DER ELEKTRISCHEN EIGENSCHAFTEN EINER WINDENERGIEANLAGE**

METHOD AND ARRANGEMENT FOR DETERMINING THE ELECTRICAL PROPERTIES OF A WIND TURBINE

PROCÉDÉ ET DISPOSITIF POUR DÉTERMINER LES PROPRIÉTÉS ÉLECTRIQUES D'UNE ÉOLIENNE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.09.2013 DE 102013218645**

(43) Veröffentlichungstag der Anmeldung:
**27.07.2016 Patentblatt 2016/30**

(73) Patentinhaber: **Senvion GmbH**
**22297 Hamburg (DE)**

(72) Erfinder: **LETAS, Heinz-Hermann**
**24796 Bovenau (DE)**

(74) Vertreter: **Glawe, Delfs, Moll**
**Partnerschaft mbB**
**von Patent- und Rechtsanwälten**
**Postfach 13 03 91**
**20103 Hamburg (DE)**

(56) Entgegenhaltungen:
EP-A1- 1 795 907     EP-B1- 1 224 721
US-A1- 2013 207 393

• A Morales ET AL: "Assessment of Wind Power Quality: Implementation of IEC61400-21 Procedures", of Solbosch - Brussels (Belgium), 16. März 2005 (2005-03-16), XP055156391, Gefunden im Internet: URL:http://www.icrepq.com/full-paper-icrep /333_MORALES.pdf [gefunden am 2014-12-03]
• Ana Morales ET AL: "C C I I POWER QUALITY RESPONSIBILITIES BY GRID IMPEDANCE ASSESSMENT AT A WIND POWER PRODUCTION", , 12. Mai 2003 (2003-05-12), XP55156383, Gefunden im Internet: URL:http://www.cired.net/publications/cire d2003/data/academic_village/Morales_AV.doc [gefunden am 2014-12-03]
• S. TENTZERAKIS ET AL: "Measurement of wind farm harmonic emissions", PESC RECORD. 27TH ANNUAL IEEE POWER ELECTRONICS SPECIALISTS CONFERENCE, 1. Juni 2008 (2008-06-01), Seiten 1769-1775, XP55154206, ISSN: 0275-9306, DOI: 10.1109/PESC.2008.4592199 ISBN: 978-0-78-033500-4
• SHUN LIANG ET AL: "A survey of harmonic emissions of a commercial operated wind farm", INDUSTRIAL AND COMMERCIAL POWER SYSTEMS TECHNICAL CONFERENCE (I&CPS), 2010 IEEE, IEEE, PISCATAWAY, NJ, USA, 9. Mai 2010 (2010-05-09), Seiten 1-8, XP031693181, ISBN: 978-1-4244-5600-0

- C. CHEN ET AL: "Critical Impedance Method-A New Detecting Harmonic Sources Method in Distribution Systems", IEEE TRANSACTIONS ON POWER DELIVERY, Bd. 19, Nr. 1, 1. Januar 2004 (2004-01-01), Seiten 288-297, XP55154205, ISSN: 0885-8977, DOI: 10.1109/TPWRD.2003.820424

- ZBIGNIEW LEONOWICZ: "Assessment of power quality in wind power systems", ENVIRONMENT AND ELECTRICAL ENGINEERING (EEEIC), 2011 10TH INTERNATIONAL CONFERENCE ON, IEEE, 8. Mai 2011 (2011-05-08), Seiten 1-3, XP031946855, DOI: 10.1109/EEEIC.2011.5874665 ISBN: 978-1-4244-8779-0

**Beschreibung**

Die Erfindung betrifft ein Verfahren zum Ermitteln der elektrischen Eigenschaften einer Windenergieanlage. Die Windenergieanlage ist dazu ausgelegt, über einen Leistungskreis elektrische Energie in ein Anschlussnetz einzuspeisen. Die Erfindung betrifft außerdem eine zugehörige Anordnung.

Wenn Windenergieanlagen elektrischen Strom in ein Anschlussnetz einspeisen, geschieht dies nicht immer mit einer idealen sinusförmigen Spannung. Aus dem Betrieb des Generators oder des Umrichters können Oberschwingungen resultieren, die von der Grundfrequenz des Anschlussnetzes abweichen und die sich der Grundschwingung überlagern. Solche Oberschwingungen sind unerwünscht, weil sie die Stabilität des Anschlussnetzes beeinträchtigen können, siehe EP 1 224 721 B1, Badrzadeh et al., Power System Harmonic Analysis in Wind Power Plants, ISBN 978-1-4673-0332-3.

Ein Strom-Kennwert der Windenergieanlage, der die von der Windenergieanlage erzeugten Oberschwingungen repräsentiert, ist unter verschiedenen Gesichtspunkten von Interesse. So werden von den Netzbetreibern Grenzwerte für die Oberschwingungen festgesetzt, die die Windenergieanlagen nicht überschreiten dürfen, wenn sie elektrische Energie in das Anschlussnetz einspeisen. Anhand des Strom-Kennwerts kann festgestellt werden, ob die Windenergieanlage die Oberschwingungs-Grenzwerte einhält. Außerdem kann ein solcher Strom-Kennwert bei der Auslegung von Windenergieanlagen oder Windparks berücksichtigt werden, indem die Windenergieanlage bzw. der Windpark so ausgelegt werden, dass der Anteil der unerwünschten Oberschwingungen möglichst gering ist.

Wenn eine Windenergieanlage elektrische Energie in das Anschlussnetz einspeist, ist es möglich, eine Messung des elektrischen Stroms vorzunehmen und zu ermitteln, in welchem Umfang dort Oberschwingungen enthalten sind. Allerdings ist es nicht möglich, aus einer solchen Messung einen unmittelbaren Rückschluss auf die elektrischen Eigenschaften der Windenergieanlage zu ziehen, weil eine Wechselwirkung zwischen dem Anschlussnetz und der Windenergieanlage besteht. Stellt man also durch die Messung fest, dass Oberschwingungen vorhanden sind, so lässt sich nicht feststellen, ob diese durch das Anschlussnetz oder durch die Windenergieanlage verursacht wurden.

In Morales et al., "Assessment of Wind Power Quality: Implementation of IEC61400-21 Procedures" (abgerufen unter: hhtp://www.icrepq.com/full-paper-icrep/333_MORALES.pdf)ist ein Verfahren zum Überprüfen der Qualität der eingespeisten Leistung beschrieben, das in Einklang mit der Norm IEC 61400-21 steht.

Der Erfindung liegt die Aufgabe zu Grunde, ein Verfahren und eine Anordnung vorzustellen, mit denen ermittelt werden kann, in welchem Umfang eine Windenergieanlage Oberschwingungen erzeugt. Ausgehend vom eingangs genannten Stand der Technik wird die Aufgabe gelöst mit den Merkmalen der unabhängigen Ansprüche. Vorteilhafte Ausführungsformen finden sich in den Unteransprüchen.

Bei dem Verfahren wird eine komplex-frequenzabhängige Strommessung durchgeführt, wenn die Windenergieanlage in einem aktiven Zustand ist, in dem sie über den Leistungskreis elektrischen Strom in das Anschlussnetz einspeist. Bei dem Verfahren wird ferner eine komplex-frequenzabhängige Spannungsmessung durchgeführt, wenn die Windenergieanlage in einem passiven Zustand ist, in dem sie keinen elektrischen Strom in das Anschlussnetz einspeist. Dabei ist unerheblich, ob die komplex-frequenzabhängige Spannungsmessung vor oder nach der komplex-frequenzabhängigen Strommessung durchgeführt wird.

Aus der komplex-frequenzabhängigen Spannungsmessung und einer komplex-frequenzabhängigen Impedanz des Leistungskreises der Windenergieanlage wird ein Netz-Vorbelastungswert ermittelt. Ein Strom-Kennwert der Windenergieanlage wird als Differenz aus der komplex-frequenzabhängigen Strommessung und dem Netz-Vorbelastungswert ermittelt.

Zunächst werden einige Begriffe erläutert. Eine Strommessung bzw. eine Spannungsmessung sind komplex-frequenzabhängig, wenn in dem Messwert eine Information sowohl über die Amplitude als auch über die Phase der gemessenen Größe enthalten ist. Entsprechend wird von einer komplex-frequenzabhängigen Impedanz gesprochen, wenn diese nach Betrag und Phase bekannt ist.

Der Begriff Leistungskreis bezeichnet die elektrischen Bauteile, die den von der Windenergieanlage erzeugten elektrischen Strom in das Anschlussnetz führen. Dazu gehören beispielsweise der Generator und der Umrichter. Im Rahmen der Erfindung werden nur diejenigen elektrischen Bauteile als zum Leistungskreis gehörig betrachtet, die zwischen dem Messpunkt der komplex-frequenzabhängigen Spannungsmessung und der Rotorwelle angeordnet sind.

Der Erfindung liegen die folgenden Gedanken zu Grunde. Mit der komplex-frequenzabhängigen Strommessung werden die am Messpunkt vorliegenden Oberschwingungen erfasst, wobei es jedoch nicht möglich ist, den von der Windenergieanlage verursachten Anteil zu unterscheiden von dem Anteil, der aus dem Anschlussnetz stammt. Es wird deswegen der Netz-Vorbelastungswert bestimmt, der dem Anteil entspricht, der von dem Anschlussnetz verursacht ist. Bildet man die Differenz aus dem Gesamtwert, der aus der komplex-frequenzabhängigen Strommessung bekannt ist, und dem Netz-Vorbelastungswert, ergibt sich der erfindungsgemäße Strom-Kennwert, der den von der Windenergieanlage verursachte Anteil der Oberschwingungen repräsentiert.

Der Netz-Vorbelastungswert, der durch unmittelbare Messung nicht zugänglich ist, wird bei dem erfindungsgemäßen Verfahren auf einem indirekten Weg bestimmt. Für die indirekte Ermittlung werden einerseits die komplex-frequenzabhängige Spannungsmessung und andererseits die komplex-frequenzabhängige Impedanz des Leistungskreises herangezogen. Aus der Spannungsmessung ergibt sich, welche Oberschwingungen das Anschlussnetz mit sich führt. Wenn die komplex-frequenzabhängige Impedanz des Leistungskreises bekannt ist, kann berechnet werden, welche Oberschwingungsströme durch die Oberschwingungen des Anschlussnetzes in den Leistungskreis eingeprägt werden.

Die komplex-frequenzabhängige Impedanz des Leistungskreises wird bei dem erfindungsgemäßen Verfahren als bekannt vorausgesetzt. Die Ermittlung der komplex-frequenzabhängigen Impedanz des Leistungskreises ist möglich anhand der bekannten elektrischen Eigenschaften der Bauteile des Leistungskreises. Wenn die elektrischen Eigenschaften von beispielsweise dem Generator und dem Umrichter bekannt sind, lässt sich die komplex-frequenzabhängige Impedanz des jeweiligen Bauteils errechnen. Führt man die komplex-frequenzabhängige Impedanz mehrerer Bauteile zusammen, ergibt sich die komplex-frequenzabhängige Impedanz des Leistungskreises.

In dem erfindungsgemäß ermittelten Strom-Kennwert der Windenergieanlage ist eine Information über den von der Windenergieanlage erzeugten Anteil an Oberschwingungen enthalten. Der Strom-Kennwert kann der Windenergieanlage also als Kenngröße zugeordnet werden. Der erfindungsgemäß ermittelte Strom-Kennwert kann zu verschiedenen Zwecken verwendet werden. Beispielsweise kann anhand des Strom-Kennwerts festgestellt werden, ob die Windenergieanlage den Vorgaben des Netzbetreibers genügt. Es ist auch möglich, den Strom-Kennwert dazu zu nutzen, die Windenergieanlage zu optimieren. Beispielsweise können die Parameter des Umrichters oder eines Filters so verändert werden, dass weniger Oberschwingungen erzeugt werden. Außerdem ist es möglich, den Betrieb eines Windparks anhand des erfindungsgemäß ermittelten Strom-Kennwerts zu optimieren. Beispielsweise können in einem Windpark mehrere Windenergieanlagen so zusammengeschlossen werden, dass bestimmte Oberschwingungen gegenphasig sind, sich also gegenseitig ausgleichen.

Um die zur Ermittlung des erfindungsgemäßen Strom-Kennwerts erforderlichen Berechnungen zu erleichtern, ist es von Vorteil, wenn die komplex-frequenzabhängige Strommessung und die komplex-frequenzabhängige Spannungsmessung an demselben Messpunkt durchgeführt werden. Von demselben Messpunkt wird gesprochen, wenn die Messpunkte der komplex-frequenzabhängigen Strommessung und der komplex-frequenzabhängigen Spannungsmessung so gewählt sind, dass zwischen beiden kein wesentlicher Potentialunterschied besteht. Dies bedeutet insbesondere, dass zwischen dem Messpunkt der komplex-frequenzabhängigen Strommessung und dem Messpunkt der komplex-frequenzabhängigen Spannungsmessung keine Bauteile des Leistungskreises liegen.

Allerdings ist nicht ausgeschlossen, für die komplex-frequenzabhängige Strommessung und die komplex-frequenzabhängige Spannungsmessung unterschiedliche Messpunkte zu verwenden. Der von der Windenergieanlage erzeugte elektrische Strom wird regelmäßig durch einen Transformator geleitet, mit dem die Spannung von einem niedrigeren Wert (Niederspannung) auf einen höheren Wert (Mittelspannung) transformiert wird. Beispielsweise wäre es möglich, die komplex-frequenzabhängige Strommessung auf der Niederspannungsseite des Transformators durchzuführen und die komplex-frequenzabhängige Spannungsmessung auf der Mittelspannungsseite des Transformators oder umgekehrt. Dies hat zur Folge, dass man den Netz-Vorbelastungswert und den Gesamtstrom für unterschiedliche Stellen ermittelt, so dass die unmittelbare Differenz wenig Aussagekraft hat. Um einen aussagekräftigen Strom-Kennwert zu erhalten, muss eine der beiden Messungen rechnerisch dorthin übertragen werden, wo man die andere Messung vorgenommen hat, so dass man einen vergleichbaren Wert erhält, als ob man direkt dort gemessen hätte. Im obigen Beispiel würde dies bedeuten, die Übertragungsfunktion des Transformators auf die betreffende Messung anzuwenden.

Wird der Rotor der Windenergieanlage aus dem normalen Betrieb zum Stillstand gebracht, erzeugt zwar der Generator keinen elektrischer Strom mehr, der über den Leistungskreis eingespeist werden könnte, der Leistungskreis kann aber noch elektrisch mit dem Anschlussnetz verbunden sein. Die Impedanzen des Leistungskreises stehen dann noch in einer Wechselwirkung mit dem Anschlussnetz, wodurch die komplex-frequenzabhängige Spannungsmessung verfälscht werden kann. Vorzugsweise wird die Windenergieanlage deswegen in einen Zustand gebracht, in dem der Leistungskreis elektrisch von dem Anschlussnetz getrennt ist, bevor die komplexe Spannungsmessung durchgeführt wird. Elektrische Trennung bedeutet, dass keine Signale von dem Anschlussnetz in den Leistungskreis übertragen werden können. Es kann vorgesehen sein, dass für die elektrische Trennung ein Trennschalter geöffnet wird. Der Messpunkt für die komplex-frequenzabhängige Spannungsmessung wird so gewählt, dass die Trennstelle zwischen dem Leistungskreis und dem Messpunkt liegt. Auf diese Weise wird die Spannung im Anschlussnetz unverfälscht gemessen. Ein solcher Trennschalter empfiehlt sich insbesondere für DFIG-Anlagen mit doppelt gespeister Asynchronmaschine, bei denen eine direkte elektrische Verbindung zwischen dem Transformator und dem Generator besteht. Die sogenannten Vollumrichter-Windenergieanlagen, bei denen die gesamte mit dem Generator erzeugte elektrische Energie durch den Umrichter geleitet wird, können so gestaltet sein, dass sich die elektrische Trennung beim Stillstand des Rotors auch ohne einen zusätzlichen Trennschalter einstellt.

Die komplex-frequenzabhängige Impedanz bezieht sich auf den Leistungskreis, den das Anschlussnetz "sieht". Es geht also um die elektrischen Bauteile, die zwischen dem Messpunkt der komplex-frequenzabhängigen Spannungsmessung und der Rotorwelle angeordnet sind. Regelmäßig gehören dazu der Generator und der Umrichter. Es können dort weitere elektrische Bauteile angeordnet sein, wie beispielsweise Filter. Ob auch der Transformator in die komplex-frequenzabhängige Impedanz einzubeziehen ist, hängt davon ab, ob der Messpunkt der komplex-frequenzabhängigen Spannungsmessung auf der Niederspannungsseite oder der Mittelspannungsseite des Transformators angeordnet ist. Bei einer komplex-frequenzabhängigen Spannungsmessung auf der Niederspannungsseite gehört der Transformator nicht zu dem Leistungskreis, den das Anschlussnetz sieht, und die komplex-frequenzabhängige Impedanz des Transformators bleibt unberücksichtigt. Bei einer komplex-frequenzabhängigen Spannungsmessung auf der Mittelspannungsseite sieht das Anschlussnetz den Transformator, und die komplex-frequenzabhängige Impedanz des Transformators muss berücksichtigt werden.

Wird die komplex-frequenzabhängige Impedanz des Leistungskreises rechnerisch ermittelt, ergeben sich in der komplex-frequenzabhängigen Impedanz regelmäßig Polstellen und Nullstellen. Wenn bei der Berechnung des Netz-Vorbelastungswerts die komplex-frequenzabhängige Spannungsmessung durch die komplex-frequenzabhängige Impedanz dividiert wird, ergeben sich rechnerisch sehr hohe Strombeträge, die tatsächlich nicht auftreten. Ein realistischeres Ergebnis erhält man, wenn vor der Berechnung des Netz-Vorbelastungswerts die Nullstellen der komplex-frequenzabhängigen Impedanz gekappt werden. Es kann dazu ein geeigneter Schwellwert festgelegt werden und der Betrag der Impedanz gleich diesem Schwellwert gesetzt werden bei allen Werten, bei denen der Betrag rechnerisch kleiner wäre.

Durch den Umrichter kann der Phasenwinkel zwischen Strom und Spannung variiert werden. Grundsätzlich kann das Verfahren bei unterschiedlichen Phasenwinkeln zwischen Strom und Spannung durchgeführt werden. Um Störeffekte auszuschließen und die Berechnung zu erleichtern, ist es aber von Vorteil, wenn für die komplex-frequenzabhängige Strommessung die Grundfrequenz des Stroms und die Grundfrequenz der Spannung in Phase sind. Für den Phasenwinkel $\varphi$ gilt dann $\varphi=0$ bzw. $\cos \varphi=1$.

In den Strom-Kennwert fließt eine verfälschte Information ein, falls während der komplex-frequenzabhängigen Spannungsmessung andere Oberschwingungen in dem Anschlussnetz anliegen als während der komplex-frequenzabhängigen Strommessung. Es sollte also darauf geachtet werden, dass der Zustand des Anschlussnetzes während der komplex-frequenzabhängigen Strommessung und der komplex-frequenzabhängigen Spannungsmessung möglichst gleich ist. Die Unsicherheit kann reduziert werden, indem die komplex-frequenzabhängige Strommessung und die komplex-frequenzabhängige Spannungsmessung jeweils in einer Mehrzahl von Messzeiträumen vorgenommen werden, wobei zwischen den Messzeiträumen zwischen Strommessungen und Spannungsmessungen hin- und hergewechselt wird. Weichen die Messergebnisse in einzelnen Messzeiträumen deutlich vom Durchschnitt ab, können diese Messzeiträume aussortiert werden und unberücksichtigt bleiben.

Die komplex-frequenzabhängige Strommessung und die komplex-frequenzabhängige Spannungsmessung werden üblicherweise als Zeitreihe aufgenommen, in der der Betrag (Amplitude) von Strom und Spannung über der Zeit aufgetragen sind. In einer solchen Zeitreihe ist jeweils die Information über die Frequenz, die Amplitude und die Phase der Schwingung enthalten, so dass es sich um eine komplex-frequenzabhängige Strommessung und eine komplex-frequenzabhängige Spannungsmessung im Sinne der Erfindung handelt. Für die nachfolgenden Berechnungen ist es von Vorteil, die komplex-frequenzabhängige Strommessung und die komplex-frequenzabhängige Spannungsmessung von der Zeitdarstellung in eine Frequenzdarstellung zu transformieren. In der Frequenzdarstellung sind die Amplitude und die Phase über der Frequenz aufgetragen. Anschaulich darstellen lässt sich die komplex-frequenzabhängige Messung beispielsweise in Form zweier Diagramme, wobei ein Diagramm die Amplitude über der Frequenz zeigt und das andere Diagramm den Phasenwinkel über der Frequenz zeigt. In einer anderen Darstellungsform wäre jeder Frequenz ein Zeiger in der komplexen Ebene zugeordnet. Diese Darstellung entspricht einer einzelnen Phase des Drehstromsystems. Entsprechende Darstellungen können für die anderen Phasen des Drehstromsystems erstellt werden, wobei die Werte voneinander abweichen können.

Liegt auch die komplex-frequenzabhängige Impedanz, die aus den bekannten elektrischen Eigenschaften des Leistungskreises rechnerisch ermittelt wird, in Frequenzdarstellung vor, so lassen sich die erforderlichen Rechenschritte leicht durchführen. Zum Ermitteln des Netz-Vorbelastungswerts wird die komplex-frequenzabhängige Spannungsmessung durch die komplex-frequenzabhängige Impedanz dividiert. Anschließend wird der Netz-Vorbelastungswert von der komplex-frequenzabhängigen Strommessung subtrahiert.

Da eine Transformation zwischen Zeitdarstellung und Frequenzdarstellung im Allgemeinen ohne Informationsverlust durchgeführt werden kann, wäre es auch möglich, alle Berechnungen in der Zeitdarstellung durchzuführen und auf die Transformation in die Frequenzdarstellung zu verzichten. Allerdings kann die komplex-frequenzabhängige Impedanz einfacher in der Frequenzdarstellung ermittelt werden, weswegen der Weg über die Frequenzdarstellung meist schneller zum Ziel führt.

Führt man die erfindungsgemäße Berechnung auf diese Weise durch, so ergibt sich ein Strom-Kennwert, der eine Information über Betrag und Phase des eingespeisten Stroms enthält. Da die von dem Anschlussnetz verursachten Stromanteile durch den Netz-Vorbelastungswert aus dem Gesamtstrom herausgerechnet wurden, betrifft der Strom-Kennwert nur die von der Windenergieanlage selbst erzeugten Stromanteile. Liegt der Strom-Kennwert in Frequenzdarstellung vor, ist für jede Frequenz ersichtlich, welche Amplitude der eingespeiste Strom hat und wie die Phasenlage relativ zu der Grundschwingung ist.

Insbesondere enthält der Strom-Kennwert regelmäßig eine Information über die harmonischen Oberschwingungen der Grundschwingung, deren Frequenz ein ganzzahliges Vielfaches der Grundfrequenz ist. Zu den harmonischen Oberschwingungen gehören insbesondere bei doppelt gespeisten Asynchrongeneratoren die generatorypischen Oberschwingungen, die phasenstarr bezogen auf die Grundschwingung sind. Außerdem enthält der Strom-Kennwert normalerweise Informationen über so genannte zwischenharmonische Oberschwingungen, deren Frequenzen kein ganzzahliges Vielfaches der Grundfrequenz bilden und die nicht phasenstarr zur Grundfrequenz sind. Die generatortypischen Oberschwingungen haben im Hinblick auf die Stabilität des Anschlussnetzes besondere Bedeutung, weil diese sich zusammen mit der Grundfrequenz sehr weit durch das Anschlussnetz ausbreiten können. Die nichtphasenstarren Oberschwingungen sind weniger kritisch, weil diese im Anschlussnetz schneller abklingen.

Der erfindungsgemäß ermittelte Strom-Kennwert kann in verschiedener Hinsicht von Nutzen sein. Zunächst ist es möglich, der Windenergieanlage eine Kenngröße zuzuordnen, in der die Informationen aus dem Strom-Kennwert teilweise oder vollständig enthalten sind. Es ist nicht für jeden Anwendungszweck erforderlich, die Informationen aus dem Strom-Kennwert vollständig zu verwerten. So ist etwa für eine Kompatibilitätsprüfung der Windenergieanlage mit den Anforderungen des Netzbetreibers in erster Linie die Amplitude der Oberschwingung von Interesse, während die Phasenlage geringere Bedeutung hat. Für diesen Anwendungszweck ist also eine Kenngröße ausreichend, in der lediglich eine Amplitudeninformation enthalten ist.

In einem anderen Anwendungsfall kann der Strom-Kennwert dazu dienen, den Betrieb der Windenergieanlage zu optimieren. Beispielsweise können die Betriebsparameter eines Bauteils des Leistungskreises verändert werden, so dass sich der Anteil bestimmter Oberschwingungen in dem eingespeisten Strom vermindert. Alternativ können die Betriebsparameter so verändert werden, dass die Phase bestimmter Oberschwingungen verschoben wird, so dass sie zu im Anschlussnetz schon vorhandenen Oberschwingungen entgegengesetzt ist. Die Oberschwingungen heben sich dann auf, so dass sich der Anteil an Oberschwingungen im Anschlussnetz insgesamt vermindert. Für diesen Zweck ist es hilfreich, wenn das erfindungsgemäße Verfahren nicht nur einmal, sondern mehrfach durchgeführt wird. Beispielsweise kann im Betrieb der Windenergieanlage in regelmäßigen Abständen eine komplex-frequenzabhängige Strommessung durchgeführt werden und in Phasen des Stillstands der Windenergieanlage komplex-frequenzabhängige Spannungsmessungen. Damit kann die Windenergieanlage geeignet reagieren, falls die charakteristischen Eigenschaften des Anschlussnetzes sich ändern, beispielsweise weil zusätzliche Windenergieanlagen an das Anschlussnetz angeschlossen wurden.

Eine dritte Möglichkeit könnte sein, den Strom-Kennwert bei der Auslegung eines Windparks zu berücksichtigen. Beispielsweise könnte man bei der Errichtung eines Windparks eine Mehrzahl von Windenergieanlagen so zueinander beabstanden, dass die Oberschwingungen sich gegenseitig wenigstens teilweise aufheben. Gegenstand dieses Verfahrens sind wenigstens zwei Windenergieanlagen, vorzugsweise mehr als zwei Windenergieanlagen. Die Möglichkeit, dass die Oberschwingungen sich bei geeignetem Abstand der Windenergieanlagen zueinander gegenseitig aufheben, besteht in erster Linie bei nicht-phasenstarren Oberschwingungen, deren Phase sich im Anschlussnetz relativ zu der Grundschwingung verschiebt. Bei den phasenstarren Oberschwingungen, deren Phasenlage relativ zu der Grundschwingung konstant ist, besteht diese Möglichkeit weniger. Alternativ oder zusätzlich dazu kann zum gegenseitigen Aufheben der Oberschwingungen ein sogenannter Schwenktransformator vorgesehen sein, der dazu ausgelegt ist, gezielt die Phasenlage bestimmter Oberschwingungen zu verschieben.

Die Erfindung betrifft außerdem eine Anordnung zum Ermitteln der elektrischen Eigenschaften einer Windenergieanlage. Die Anordnung umfasst eine Windenergieanlage, die dazu ausgelegt ist, über einen Leistungskreis elektrischen Strom in ein Anschlussnetz einzuspeisen. Die Anordnung umfasst ferner einen Stromsensor zum Durchführen einer komplex-frequenzabhängigen Strommessung in einem aktiven Zustand der Windenergieanlage, in dem die Windenergieanlage über den Leistungskreis elektrischen Strom in das Anschlussnetz einspeist, und einen Spannungssensor zum Durchführen einer komplex-frequenzabhängigen Spannungsmessung in einem passiven Zustand der Windenergieanlage, in dem die Windenergieanlage über den Leistungskreis keinen elektrischen Strom in das Anschlussnetz einspeist. Außerdem umfasst die Anordnung ein Kalkulatormodul, das dazu eingerichtet ist, aus der komplex-frequenzabhängigen Spannungsmessung und einer komplex-frequenzabhängigen Impedanz des Leistungskreises der Windenergieanlage einen Netz-Vorbelastungswert zu ermitteln sowie aus der Differenz der komplex-frequenzabhängigen Strommessung und dem Netz-Vorbelastungswert einen Strom-Kennwert der Windenergieanlage zu ermitteln. Die Anordnung kann mit weiteren Merkmalen fortgebildet werden, die im Zusammenhang des erfindungsgemäßen Verfahrens beschrieben sind.

Erfindung wird nachfolgend unter Bezugnahme auf die beigefügten Zeichnungen anhand vorteilhafter Ausführungsform beispielhaft beschrieben. Es zeigen:

Fig. 1:   eine schematische Darstellung eines Windparks, in dem das erfindungsgemäße Verfahren durchgeführt werden kann;

Fig. 2:   eine Strommessung in Zeitdarstellung;

Fig. 3:   eine Strommessung in Frequenzdarstellung;

Fig. 4:   eine schematische Darstellung einer Windenergieanlage;

Fig. 5:   eine Darstellung der komplex-frequenzabhängigen Impedanz eines Leistungskreises;

Fig. 6:   eine erfindungsgemäße Anordnung;

Fig. 7:   einen Ausschnitt aus einem erfindungsgemäß gestalteten Windpark.

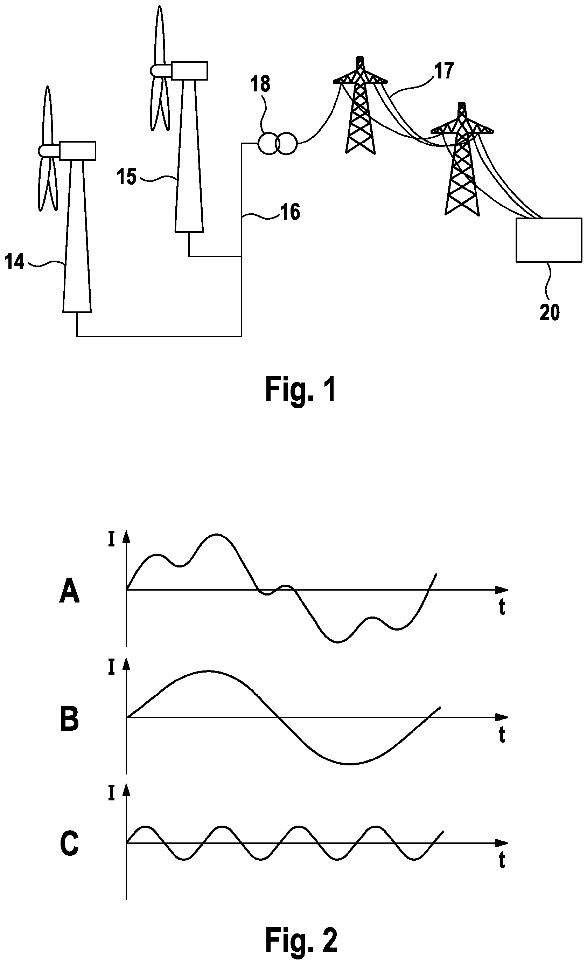

In einem Windpark in Fig. 1 ist eine Mehrzahl von Windenergieanlagen 14, 15 an ein windparkinternes Anschlussnetz 16 angeschlossen. In dem Anschlussnetz 16 liegt eine Mittelspannung von beispielsweise 20 kV an. Vor der Übergabe an ein öffentliches Übertragungsnetz 17 wird die Spannung mit einem Transformator 18 auf eine Hochspannung von beispielsweise 380 kV transformiert. An das Übertragungsnetz 17 ist eine Vielzahl von Verbrauchern 20 angeschlossen, die in Fig. 1 nur schematisch angedeutet sind.

Misst man den elektrischen Strom, den beispielsweise die Windenergieanlage 14 in das Anschlussnetz 16 einspeist, so können die Strom-Messwerte über der Zeit aufgetragen werden. Ein einfaches Beispiel für ein Ergebnis einer solchen Messung ist in Fig. 2 dargestellt. Der tatsächliche Verlauf der Strom-Messwerte gemäß Fig. 2A ist eine Überlagerung aus einer Grundschwingung (Fig. 2B) und einer Oberschwingung (Fig. 2C). Die Grundfrequenz entspricht der Frequenz der Spannung im Anschlussnetz und kann beispielsweise 50 Hz betragen. Die in Fig. 2C gezeigte Oberschwingung hat eine Frequenz von 200 Hz, was eine anschauliche Darstellung der Überlagerung ermöglicht. In der Praxis haben die fünffache Oberschwingung (250 Hz) und die siebenfache Oberschwingung (350 Hz) eine größere Relevanz als die vierfache Oberschwingung (200 Hz). Die Frequenz der Oberschwingung ist ein ganzzahliges Vielfaches der Grundfrequenz, es handelt sich also um eine harmonische Oberschwingung, die phasenstarr zu der Grundschwingung ist. Der Nulldurchgang der Grundschwingung fällt mit dem Nulldurchgang der Oberschwingung zusammen, die beiden Schwingungen sind also in Phase mit einem Phasenwinkel von $\varphi=0$. Da in dem Messergebnis eine Information sowohl über den Betrag der Oberschwingung als auch über die Phase der Oberschwingung relativ zu der Grundschwingung enthalten ist, handelt es sich um eine komplex-frequenzabhängige Strommessung im Sinne der Erfindung.

In dem vereinfachten Anschauungsbeispiel der Fig. 2A ist die Kurve eine einfache Überlagerung aus der Grundschwingung und einer einzelnen Oberschwingung mit vierfacher Frequenz. Bei einer tatsächlichen Messung wäre der Grundschwingung eine Vielzahl von harmonischen und zwischenharmonischen Oberschwingungen überlagert, deren Amplitude in aller Regel wesentlich kleiner ist als in Fig. 2C dargestellt.

Wenn man bei einer komplex-frequenzabhängigen Strommessung der Windenergieanlage 14 ein Messergebnis wie in Fig. 2 erhält, in dem neben der Grundschwingung Oberschwingungen enthalten sind, geht daraus nicht hervor, ob die Oberschwingungen von der Windenergieanlage 14 verursacht sind oder ob die Oberschwingungen aus dem Anschlussnetz stammen. Wären im Anschlussnetz 16 Oberschwingungen enthalten, würden diese Ströme mit entsprechender Frequenz im Leistungskreis der Windanlage 14 induzieren. Man würde also bei der komplex-frequenzabhängigen Strommessung Oberschwingungen feststellen, obwohl die Windenergieanlage 14 selbst keinerlei Oberschwingungen verursacht hat.

Das erfindungsgemäße Verfahren dient dazu, den Anteil der Oberschwingungen zu ermitteln, den die Windenergieanlage verursacht hat. Von dem durch Messung zugänglichen Gesamtwert der Oberschwingungen wird dazu der Netz-Vorbelastungswert abgezogen, der den vom Anschlussnetz stammenden Anteil der Oberschwingungen repräsentiert.

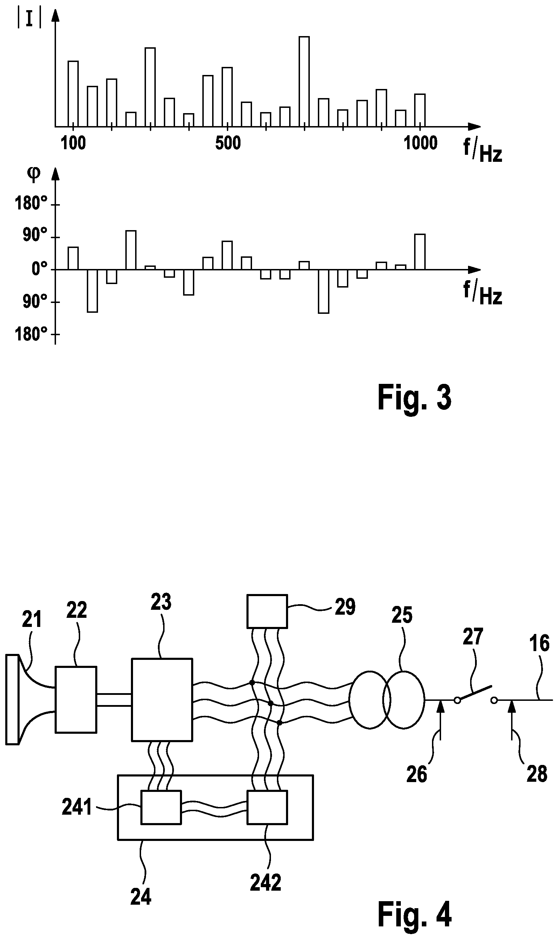

In der schematischen Darstellung der Windenergieanlage 14 in Fig. 4 wird die Drehung eines Rotors 21 durch ein Getriebe 22 auf eine höhere Drehzahl übersetzt, mit der ein Generator 23 angetrieben wird. Der von dem Generator 23 erzeugte elektrische Strom wird über eine dreiphasige Verbindung an einen U Transformator 25 weitergeleitet, der die Spannung auf die im Anschlussnetz 16 anliegende Mittelspannung bringt. Es handelt sich um eine doppelt gespeiste Asynchronmaschine (DFIG), bei der ein Filter 29 und ein Umrichter 24 zu parallel zu dem Generator 23 geschaltet sind. Der Umrichter 24 umfasst einen Machine Side Converter 241 und einen Line-Side-Converter 242, die über einen Gleichstrom-Zwischenkreis miteinander verbunden sind.

Auf der Mittelspannungsseite des Transformators 25 ist ein Stromsensor 26 angeordnet, der dazu ausgelegt ist, den eingespeisten Strom zu messen und über der Zeit aufzuzeichnen. Durch eine Fourier-Transformation können die Messwerte von der Zeitdarstellung in eine Frequenzdarstellung transformiert werden. Ein Beispiel für das Ergebnis der komplex-frequenzabhängigen Strommessung in Frequenzdarstellung ist in Fig. 3 gezeigt. Dabei ist die Darstellung auf die harmonischen Oberschwingungen der Grundfrequenz von 50 Hz beschränkt. Für jede Oberschwingung ist in einem ersten Diagramm die Amplitude, also der Betrag des Stroms, in Balkendarstellung angegeben und in einem zweiten Diagramm der Phasenwinkel $\varphi$ zwischen der betreffenden Oberschwingung und der Grundschwingung angegeben. Bezugsgröße für den Phasenwinkel $\varphi$ ist dabei die Oberschwingung. Auf die Darstellung der Grundfrequenz von 50 Hz wurde verzichtet. Entsprechende Information erhält man durch die Transformation in die Frequenzdarstellung auch für die zwischenharmonischen Oberschwingungen. In Fig. 3 sind lediglich die harmonischen Oberschwingungen zwischen 100 Hz und 1000 Hz gezeigt. In der Praxis kann die Analyse für einen größeren Frequenzbereich von beispielsweise 0,1 kHz bis 10 kHz durchgeführt werden.

Nach Abschluss der komplex-frequenzabhängigen Strommessung wird die Windenergieanlage 14 zum Stillstand gebracht und ein Trennschalter 27 geöffnet. Mit einem Spannungssensor 28 wird die in dem Anschlussnetz 16 anliegende Spannung über der Zeit gemessen. Wenn der Trennschalter 27 geschlossen ist, gibt es keinen relevanten Potentialunterschied zwischen dem Stromsensor 26 und dem Spannungssensor 28, so dass es sich im Sinne der Erfindung um denselben Messpunkt handelt. In der komplex-frequenzabhängigen Spannungsmessung ist eine Information über den Betrag und die Phase der Schwingungen enthalten. Durch eine Fourier-Transformation können die Messergebnisse von der Zeitdarstellung in die Frequenzdarstellung überführt werden, womit sich eine Darstellung ähnlich wie in Fig. 3 ergibt. Jeder Oberschwingung sind also ein Betrag und eine Phase zugeordnet.

Wäre der Schalter 27 geschlossen, würde durch die Spannung in dem Anschlussnetz 16 ein Strom in dem Leistungskreis der Windenergieanlage induziert werden. Der Leistungskreis der Windenergieanlage 14 umfasst die elektrischen Komponenten, durch die der mit dem Generator 23 erzeugte elektrische Strom bis zum Messpunkt des Spannungssensors 28 geleitet wird. In dem Ausführungsbeispiel der Fig. 4 gehören zu dem Leistungskreis also der Generator 23, der Umrichter 24 und der Transformator 25. Die elektrischen Eigenschaften sind für jede der Komponenten des Leistungskreises bekannt, so dass für jede Komponente eine komplexe Impedanz als Funktion der Frequenz f rechnerisch ermittelt werden kann. Aus den komplexen Impedanzen $Z_{gen}$ des Generators 23, $Z_{inv}$ des Umrichters 24, $Z_{tra}$ des Transformators 25 und $Z_{flt}$ des Filters 29 kann nach folgender Gleichung die komplexe Impedanz $Z_{ges}$ des Leistungskreises ermittelt werden:

$$Z_{ges} = \frac{1}{\left( \dfrac{1}{Z_{gen}} + \dfrac{1}{Z_{inv}} + \dfrac{1}{Z_{flt}} \right)} + Z_{tra}$$

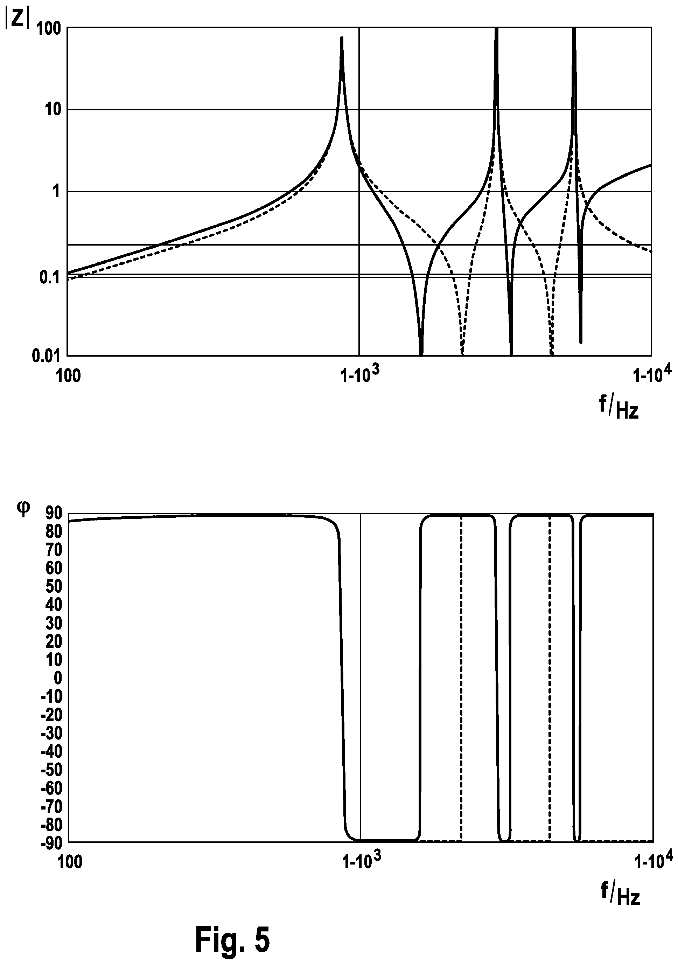

Ein Beispiel für eine so ermittelte komplexe Impedanz $Z_{ges}$ des Leistungskreises 23, 24, 25, 29 ist in Fig. 5 in gepunkteter Linien in zwei Diagrammen dargestellt. Das obere Diagramm zeigt den Betrag der komplexen Impedanz $Z_{ges}$ über der Frequenz f im Bereich von 100 Hz bis 10 kHz. Die Darstellung ist auf beiden Achsen logarithmisch. Das untere Diagramm zeigt den Phasenwinkel φ über der Frequenz f, wobei nur die Frequenz logarithmisch dargestellt ist. Die gepunktete Linie fällt teilweise mit der durchgezogenen Linie zusammen, so dass sie in diesen Abschnitten nicht von der durchgezogenen Linie zu unterscheiden ist.

Der Betrag der komplex-frequenzabhängigen Impedanz $Z_{ges}$ hat zwei Nullstellen bei etwa 2,2 kHz und 4,5 kHz, bei denen der Betrag der komplex-frequenzabhängigen Impedanz $Z_{ges}$ sehr klein ist. Um Fehler bei Division durch die komplex-frequenzabhängige Impedanz $Z_{ges}$ auszuschließen, werden die Nullstellen gekappt, beispielsweise indem alle Werte, bei denen der Betrag der komplex-frequenzabhängigen Impedanz kleiner als 0,1 ist auf 0,1 gesetzt werden. Dies ist in Fig. 5 mit einer durchgezogenen Linie angedeutet.

Zur Berechnung des Netz-Vorbelastungswerts wird die komplex-frequenzabhängige Spannungsmessung durch die komplex-frequenzabhängige Impedanz $Z_{ges}$ dividiert.

Als Differenz aus der komplex-frequenzabhängigen Strommessung und dem Netz-Vorbelastungswert ergibt sich der Strom-Kennwert der Windenergieanlage 14. Bei der Differenzbildung wird nicht lediglich der Betrag der beiden Stromwerte voneinander abgezogen, sondern die Differenz wird anhand der Vektoren gebildet, die sich aus Betrag und Phasenwinkel jeweils in der komplexen Ebene bilden lassen. Der Strom-Kennwert als Ergebnis der Differenz ist folglich wieder ein komplex-frequenzabhängiger Stromwert, in dem eine Information über den Betrag und die Phase enthalten ist. Der Strom-Kennwert kann ähnlich wie in Fig. 3 grafisch dargestellt werden.

Der Strom-Kennwert kann beispielsweise dazu genutzt werden, um die Kompatibilität der Windenergieanlage 14 mit den Anforderungen des Netzbetreibers zu überprüfen. Die Anforderungen des Netzbetreibers können so dargestellt sein, dass für bestimmte Oberschwingungen des Stroms bestimmte Betragswerte angegeben werden, die die Windenergieanlage 14 beim Einspeisen von Strom nicht überschreiten darf. Für jede Oberschwingung kann durch Vergleich des betreffenden Betragswerts des Strom-Kennwerts leicht der Vergleich mit dem betreffenden Grenzwert des Netzbetreibers durchgeführt werden. Für diesen Zweck ist es ausreichend, die Betragswerte des Strom-Kennwerts zu betrachten, während die Phasenwerte nicht relevant sind. Zum Zwecke des Vergleichs kann der Windenergieanlage 14 also eine Strom-Kenngröße zugeordnet werden, in der nur ein Teil der Informationen aus dem Strom-Kennwert enthalten ist.

Beziehen sich die Grenzwerte des Netzbetreibers nicht auf die einzelne Windenergieanlage, sondern auf den gesamten Windpark, können die Werte der einzelnen Windenergieanlagen addiert werden. Unterliegt beispielsweise die Oberschwingung von 250 Hz in dem Windpark einem Grenzwert von 20 A, können in dem Windpark zehn Windenergieanlagen zusammengeschlossen werden, die diese Oberschwingung mit 2 A einspeisen, ohne dass der Grenzwert überschritten wird. Die Grenzwerte der Netzbetreiber sind häufig so gestaltet, das harmonische Oberschwingungen mit einer höheren Gewichtung einfließen als zwischenharmonische Oberschwingungen.

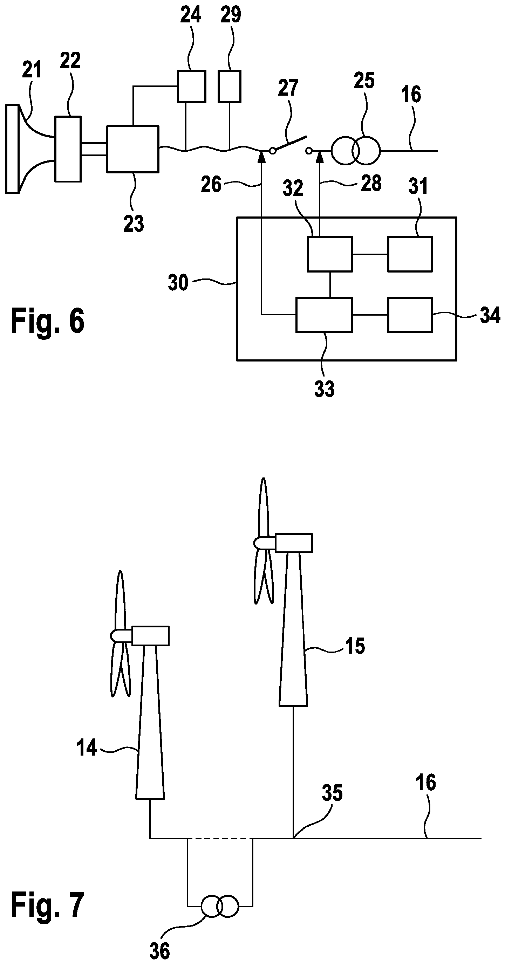

In der Ausführungsform der Fig. 6 sind der Stromsensor 26, der Trennschalter 27 und der Spannungssensor 28 auf der Niederspannungsseite des Transformators 25 angeordnet. Die Anordnung umfasst ein Kalkulatormodul 30, in dem die weiteren Schritte des erfindungsgemäßen Verfahrens automatisch durchgeführt werden. Das Modul umfasst einen ersten Speicher 31, in dem die komplex-frequenzabhängige Impedanz des Leistungskreises gespeichert ist. Die komplex-frequenzabhängige Impedanz bezieht sich auf den Leistungskreis, den das Anschlussnetz 16 vom Messpunkt der Spannungsmessung aus "sieht". In dem Ausführungsbeispiel der Fig. 6 umfasst der Leistungskreis nur den Generator 23 den Umrichter 24 und das Filter 29, nicht aber den Transformator 25. Die komplex-frequenzabhängige Impedanz $Z_{ges}$ berechnet sich aus den komplex-frequenzabhängigen Impedanzen des Generators $Z_{gen}$, des Umrichters $Z_{inv}$ und des Filters $Z_{flt}$ nach folgender Formel:

$$Z_{ges} = \cfrac{1}{\left( \cfrac{1}{Z_{gen}} + \cfrac{1}{Z_{inv}} + \cfrac{1}{Z_{flt}} \right)}$$

Ein Beispiel für die komplex-frequenzabhängige Impedanz dieses Leistungskreises zeigt die durchgezogene Linie in Fig. 5. In der komplex-frequenzabhängigen Impedanz $Z_{ges}$, die in dem Speicher 31 hinterlegt ist, sind die Nullstellen des Impedanzbetrags gekappt und auf den Wert 0,1 gesetzt.

Ein Divisionsmodul 32 ist dazu ausgelegt, die Division zwischen der komplex-frequenzabhängigen Spannungsmessung und der komplex-frequenzabhängigen Impedanz durchzuführen, um den Netz-Vorbelastungswert zu ermitteln. Ein Differenzmodul 33 bildet die Differenz zwischen der komplex-frequenzabhängigen Strommessung und dem Netz-Vorbelastungswert, um den Strom-Kennwert zu ermitteln. Der Strom-Kennwert wird in einem zweiten Speicher 34 abgelegt.

In Fig. 7 ist ein Ausschnitt aus einem Windpark gezeigt, bei dessen Gestaltung der in dem Speicher 34 gespeicherte Strom-Kennwert der Windenergieanlage 14 berücksichtigt wurde. Aus dem Strom-Kennwert ergibt sich, dass eine bestimmte zwischenharmonischer Oberschwingung in dem von der Windenergieanlage 14 erzeugten Strom besonders ausgeprägt ist. Die Verbindungsleitung zu der Windenergieanlage 15 ist mittels eines Schwenktransformators 36 so gestaltet, dass die betreffenden Oberschwingungen der beiden Windenergieanlage 14, 15 gerade gegenläufig sind, sich also gegenseitig ausgleichen. Anstatt des gestrichelt dargestellten direkten Wegs nimmt die Verbindungsleitung den Weg über den Schwenktransformator 36, so dass sich an dem Verknüpfungspunkt 35 die gewünschte Phasenverschiebung dieser Oberschwingung einstellt.

**Patentansprüche**

1. Verfahren zum Ermitteln der elektrischen Eigenschaften einer Windenergieanlage (14, 15), wobei die Windenergieanlage (14, 15) dazu ausgelegt ist, über einen Leistungskreis (23, 24, 25, 29) elektrischen Strom in ein Anschlussnetz (16) einzuspeisen, mit folgenden Schritten:

   a. Durchführen einer komplex-frequenzabhängigen Strommessung (26) in einem aktiven Zustand der Windenergieanlage (14, 15), in dem die Windenergieanlage (14, 15) über den Leistungskreis (23, 24, 25, 29) elektrischen Strom in das Anschlussnetz (16) einspeist;
   b. Durchführen einer komplex-frequenzabhängigen Spannungsmessung (28) in einem passiven Zustand der Windenergieanlage (14, 15), in dem die Windenergieanlage (14, 15) über den Leistungskreis (23, 24, 25, 29) keinen elektrischen Strom in das Anschlussnetz (16) einspeist;
   c. Ermitteln eines Netz-Vorbelastungswerts aus der komplex-frequenzabhängigen Spannungsmessung (28) und einer komplex-frequenzabhängigen Impedanz ($Z_{ges}$) des Leistungskreises (23, 24, 25, 29) der Windenergieanlage (14, 15), wobei der Netz-Vorbelastungswert dem von dem Anschlussnetz (16) verursachten Anteil an Oberschwingungen entspricht;
   d. Ermitteln eines Strom-Kennwerts der Windenergieanlage (14, 15) als Differenz aus der komplex-frequenzabhängigen Strommessung (26) und dem Netz-Vorbelastungswert.

2. Verfahren nach Anspruch 1, **dadurch gekennzeichnet, dass** für die komplex-frequenzabhängige Strommessung (26) und die komplex-frequenzabhängige Spannungsmessung (28) derselbe Messpunkt verwendet wird.

3. Verfahren nach Anspruch 1 oder 2, **dadurch gekennzeichnet, dass** die komplex-frequenzabhängige Strommessung (26) und die komplex-frequenzabhängige Spannungsmessung (28) auf der Niederspannungsseite des Transformators (25) durchgeführt werden.

4. Verfahren nach Anspruch 1 oder 2, **dadurch gekennzeichnet, dass** die komplex-frequenzabhängige Strommessung (26) und die komplex-frequenzabhängige Spannungsmessung (28) auf der Mittelspannungsseite des Transformators (25) durchgeführt werden.

5. Verfahren nach einem der Ansprüche 1 bis 4, **dadurch gekennzeichnet, dass** vor der komplex-frequenzabhängigen Spannungsmessung (28) ein Trennschalter (27) zwischen dem Leistungskreis (23, 24) und dem Anschlussnetz (16) geöffnet wird.

6. Verfahren nach einem der Ansprüche 1 bis 5, **dadurch gekennzeichnet, dass** vor der Berechnung des Netz-Vorbelastungswerts die Nullstellen der komplex-frequenzabhängigen Impedanz ($Z_{ges}$) gekappt werden.

7. Verfahren nach einem der Ansprüche 1 bis 6, **dadurch gekennzeichnet, dass** während der komplex-frequenzabhängigen Strommessung (26) der eingespeiste Strom mit der Spannung in Phase ist.

8. Verfahren nach einem der Ansprüche 1 bis 7, **dadurch gekennzeichnet, dass** die komplex-frequenzabhängige Strommessung (26) und die komplex-frequenzabhängige Spannungsmessung (28) jeweils in einer Mehrzahl von Messzeiträumen vorgenommen werden, wobei zwischen den Messzeiträumen zwischen Strommessungen (26) und Spannungsmessungen (28) hin- und her gewechselt wird.

9. Verfahren nach einem der Ansprüche 1 bis 8, **dadurch gekennzeichnet, dass** die komplex-frequenzabhängige Spannungsmessung (28) als Zeitreihe aufgenommen wird und dass vor der Ermittlung des Netz-Vorbelastungswerts eine Transformation der komplex-frequenzabhängigen Spannungsmessung (28) in eine Frequenzdarstellung vorgenommen wird.

10. Verfahren nach einem der Ansprüche 1 bis 9, **dadurch gekennzeichnet, dass** in dem Strom-Kennwert ein Wert für die Amplitude einer Oberschwingung enthalten ist und dass dieser Wert mit einem vom Netzbetreiber vorgegebenen Grenzwert verglichen wird.

11. Verfahren nach einem der Ansprüche 1 bis 10, **dadurch gekennzeichnet, dass** in dem Strom-Kennwert ein Wert für den Phasenwinkel zwischen einer Oberschwingung und der Grundschwingung enthalten ist und dass ein Betriebsparameter des Leistungskreises (23, 24, 25, 29) so angepasst wird, dass der Phasenwinkel der Oberschwingung verändert wird.

12. Verfahren nach einem der Ansprüche 1 bis 11, **dadurch gekennzeichnet, dass** in dem Strom-Kennwert ein Wert für den Phasenwinkel und die Amplitude einer zwischenharmonischen Oberschwingung enthalten ist und dass bei der Errichtung eines Windparks eine Mehrzahl von Windenergieanlagen (14, 15) so miteinander verbunden wird, dass die von diesen Windenergieanlagen (14, 15) eingespeisten zwischenharmonischen Oberschwingungen sich wenigstens teilweise aufheben.

13. Anordnung zum Ermitteln der elektrischen Eigenschaften einer Windenergieanlage (14, 15), umfassend eine Windenergieanlage (14, 15), die dazu ausgelegt ist, über einen Leistungskreis (23, 24, 25, 29) elektrischen Strom in ein Anschlussnetz (16) einzuspeisen, einen Stromsensor (26) zum Durchführen einer komplex-frequenzabhängigen Strommessung in einem aktiven Zustand der Windenergieanlage (14, 15), in dem die Windenergieanlage (14, 15) über den Leistungskreis (23, 24, 25, 29) elektrischen Strom in das Anschlussnetz (16) einspeist, einen Spannungssensor (28) zum Durchführen einer komplex-frequenzabhängigen Spannungsmessung in einem passiven Zustand der Windenergieanlage (14, 15), in dem die Windenergieanlage (14, 15) über den Leistungskreis (23, 24, 25, 29) keinen elektrischen Strom in das Anschlussnetz (16) einspeist, und ein Kalkulatormodul (30), das dazu eingerichtet ist, aus der komplex-frequenzabhängigen Spannungsmessung (28) und einer komplex-frequenzabhängigen Impedanz ($Z_{ges}$) des Leistungskreises (23, 24, 25, 29) der Windenergieanlage (14, 15) einen Netz-Vorbelastungswert zu ermitteln), wobei der Netz-Vorbelastungswert dem von dem Anschlussnetz (16) verursachten Anteil an Oberschwingungen entspricht, sowie aus der Differenz der komplex-frequenzabhängigen Strommessung (26) und dem Netz-Vorbelastungswert einen Strom-Kennwert der Windenergieanlage (14, 15) zu ermitteln.

## Claims

1. Method for determining the electrical properties of a wind turbine (14, 15), wherein the wind turbine (14, 15) is designed to feed electric current to a connecting grid system (16) by means of a power circuit (23, 24, 25, 29), said method comprising the following steps:

a. carrying out a complex-frequency-dependent current measurement (26) in an active state of the wind turbine (14, 15), in which the wind turbine (14, 15) feeds electric current to the connecting grid system (16) by means of the power circuit (23, 24, 25, 29);
b. carrying out a complex-frequency-dependent voltage measurement (28) in a passive state of the wind turbine (14, 15), in which the wind turbine (14, 15) does not feed electric current to the connecting grid system (16) by means of the power circuit (23, 24, 25, 29);
c. determining a grid system base load value from the complex-frequency-dependent voltage measurement (28) and a complex-frequency-dependent impedance ($Z_{ges}$) of the power circuit (23, 24, 25, 29) of the wind turbine (14, 15), wherein the grid system base load value corresponds to the harmonic content caused by the connecting grid system (16);

d. determining a current characteristic value of the wind turbine (14, 15) as the difference between the complex-frequency-dependent current measurement (26) and the grid system base load value.

2. Method according to Claim 1, **characterized in that** the same measuring point is used for the complex-frequency-dependent current measurement (26) and the complex-frequency-dependent voltage measurement (28).

3. Method according to Claim 1 or 2, **characterized in that** the complex-frequency-dependent current measurement (26) and the complex-frequency-dependent voltage measurement (28) are carried out on the low-voltage side of the transformer (25).

4. Method according to Claim 1 or 2, **characterized in that** the complex-frequency-dependent current measurement (26) and the complex-frequency-dependent voltage measurement (28) are carried out on the medium-voltage side of the transformer (25).

5. Method according to one of Claims 1 to 4, **characterized in that** a switch disconnector (27) between the power circuit (23, 24) and the grid connecting system (16) is opened before the complex-frequency-dependent voltage measurement (28).

6. Method according to one of Claims 1 to 5, **characterized in that** the zeros of the complex-frequency-dependent impedance ($Z_{ges}$) are clipped before calculating the grid system base load value.

7. Method according to one of Claims 1 to 6, **characterized in that** the fed current is in phase with the voltage during the complex-frequency-dependent current measurement (26).

8. Method according to one of Claims 1 to 7, **characterized in that** the complex-frequency-dependent current measurement (26) and the complex-frequency-dependent voltage measurement (28) are both taken in a plurality of measurement time periods, wherein the method alternates back and forth between current measurements (26) and voltage measurements (28) between the measurement time periods.

9. Method according to one of Claims 1 to 8, **characterized in that** the complex-frequency-dependent voltage measurement (28) is recorded as a time series and **in that** a transformation of the complex-frequency-dependent voltage measurement (28) into a frequency representation is carried out before determining the grid system base load value.

10. Method according to one of Claims 1 to 9, **characterized in that** the current characteristic value contains a value for the amplitude of a harmonic and **in that** said value is compared with a limit value prescribed by the grid system operator.

11. Method according to one of Claims 1 to 10, **characterized in that** the current characteristic value contains a value for the phase angle between a harmonic and the fundamental and **in that** an operating parameter of the power circuit (23, 24, 25, 29) is adjusted in such a way that the phase angle of the harmonic is altered.

12. Method according to one of Claims 1 to 11, **characterized in that** the current characteristic value contains a value for the phase angle and the amplitude of an interharmonic and **in that**, during the construction of a wind farm, a plurality of wind turbines (14, 15) are connected to one another in such a way that the interharmonics fed by said wind turbines (14, 15) at least partially cancel out.

13. Arrangement for determining the electrical properties of a wind turbine (14, 15), comprising a wind turbine (14, 15) that is designed to feed electric current to a connecting grid system (16) by means of a power circuit (23, 24, 25, 29), a current sensor (26) for carrying out a complex-frequency-dependent current measurement in an active state of the wind turbine (14, 15), in which the wind turbine (14, 15) feeds electric current to the connecting grid system (16) by means of the power circuit (23, 24, 25, 29), a voltage sensor (28) for carrying out a complex-frequency-dependent voltage measurement in a passive state of the wind turbine (14, 15), in which the wind turbine (14, 15) does not feed electric current to the connecting grid system (16) by means of the power circuit (23, 24, 25, 29), and a calculator module (30) that is configured to determine a grid system base load value from the complex-frequency-dependent voltage measurement (28) and a complex-frequency-dependent impedance ($Z_{ges}$) of the power circuit (23, 24, 25, 29) of the wind turbine (14, 15), wherein the grid system base load value corresponds to the harmonic content caused by the connecting grid system (16), and also to determine a current characteristic value of the wind turbine (14, 15) from the difference between the complex-frequency-dependent current measurement (26) and the grid system base load value.

**Revendications**

1. Procédé pour déterminer les propriétés électriques d'une éolienne (14, 15), dans lequel l'éolienne (14, 15) est conçue pour alimenter, par le biais d'un circuit de puissance (23, 24, 25, 29), un réseau de raccordement (16) en courant électrique, comportant les étapes consistant à :

a. effectuer une mesure de courant (26) dépendant d'une fréquence complexe dans un état actif de l'éolienne (14, 15) dans lequel l'éolienne (14, 15) alimente, par le biais du circuit de puissance (23, 24, 25, 29), le réseau de raccordement (16) en courant électrique ;
b. effectuer une mesure de tension (28) dépendant d'une fréquence complexe dans un état passif de l'éolienne (14, 15), dans lequel l'éolienne (14, 15) n'alimente, par le biais du circuit de puissance (23, 24, 25, 29), le réseau de raccordement (16) avec aucun courant électrique ;
c. déterminer une valeur de précharge du réseau à partir de la mesure de tension (28) dépendant d'une fréquence complexe et d'une impédance ($Z_{ges}$) dépendant d'une fréquence complexe du circuit de puissance (23, 24, 25, 29) de l'éolienne (14, 15), dans lequel la valeur de précharge du réseau correspond à la fraction d'harmoniques provoquée par le réseau de raccordement (16) ;
d. déterminer une valeur caractéristique de courant de l'éolienne (14, 15) comme étant la différence entre la mesure de courant (26) dépendant d'une fréquence complexe et la valeur de précharge du réseau.

2. Procédé selon la revendication 1, **caractérisé en ce que** le même point de mesure est utilisé pour la mesure de courant (26) dépendant d'une fréquence complexe et la mesure de tension (28) dépendant d'une fréquence complexe.

3. Procédé selon la revendication 1 ou 2, **caractérisé en ce que** la mesure de courant (26) dépendant d'une fréquence complexe et la mesure de tension (28) dépendant d'une fréquence complexe sont effectuées du côté à basse tension du transformateur (25).

4. Procédé selon la revendication 1 ou 2, **caractérisé en ce que** la mesure de courant (26) dépendant d'une fréquence complexe et la mesure de tension (28) dépendant d'une fréquence complexe sont effectuées du côté à moyenne tension du transformateur (25).

5. Procédé selon l'une quelconque des revendications 1 à 4, **caractérisé en ce que**, avant la mesure de tension (28) dépendant d'une fréquence complexe, un disjoncteur (27) est ouvert entre le circuit de puissance (23, 24) et le réseau de raccordement (16).

6. Procédé selon l'une des revendications 1 à 5, **caractérisé en ce que**, avant le calcul de la valeur de précharge du réseau, les points de passage à zéro de l'impédance dépendant d'une fréquence complexe ($Z_{ges}$) sont écrêtés.

7. Procédé selon l'une quelconque des revendications 1 à 6, **caractérisé en ce que** le courant d'alimentation est en phase avec la tension pendant la mesure de courant (26) dépendant d'une fréquence complexe.

8. Procédé selon l'une quelconque des revendications 1 à 7, **caractérisé en ce que** la mesure de courant (26) dépendant d'une fréquence complexe et la mesure de tension (28) dépendant d'une fréquence complexe sont respectivement réalisées au cours d'une pluralité d'intervalles de temps de mesure, dans lequel une alternance est effectuée entre les mesures de courant (26) et les mesures de tension (28) entre les intervalles de temps de mesure.

9. Procédé selon l'une quelconque des revendications 1 à 8, **caractérisé en ce que** la mesure de courant (28) dépendant d'une fréquence complexe est enregistrée sous la forme d'une série temporelle et **en ce qu'**une transformation de la mesure de tension (28) dépendant d'une fréquence complexe est réalisée conformément à une représentation en fréquence avant la détermination de la valeur de précharge du réseau.

10. Procédé selon l'une quelconque des revendications 1 à 9, **caractérisé en ce qu'**une valeur de l'amplitude d'un harmonique est contenue dans la valeur caractéristique de courant et **en ce que** ladite valeur est comparée à une valeur limite prédéterminée par l'opérateur de réseau.

11. Procédé selon l'une quelconque des revendications 1 à 7, **caractérisé en ce qu'**une valeur de l'angle de phase entre un harmonique et le fondamental est contenue dans la valeur caractéristique de courant et **en ce qu'**un paramètre de fonctionnement du circuit de puissance (23, 24, 25, 29) est adapté de manière à modifier l'angle de phase de l'harmonique.

12. Procédé selon l'une quelconque des revendications 1 à 11, **caractérisé en ce qu'**une valeur de l'angle de phase et l'amplitude d'un harmonique à fréquence inter-harmonique sont contenues dans la valeur caractéristique de courant et **en ce que**, lors de la construction d'un parc d'éoliennes, une pluralité d'éoliennes (14, 15) sont reliées les unes aux autres de manière à ce que les harmoniques à fréquence inter-harmonique délivrés par lesdites éoliennes (14, 15) s'annulent au moins partiellement.

**13.** Système destiné à déterminer les propriétés électriques d'une éolienne (14, 15), comprenant une éolienne (14, 15) qui est conçue pour alimenter, par le biais d'un circuit de puissance (23, 24, 25, 29), un réseau de raccordement (16) en courant électrique, un capteur de courant (26) destiné à effectuer une mesure de courant dépendant d'une fréquence complexe dans un état actif de l'éolienne (14, 15), dans lequel l'éolienne (14, 15) alimente, par le biais du circuit de puissance (23, 24, 25, 29), le réseau de raccordement (16) en courant électrique, un capteur de tension (28) destiné à effectuer une mesure de tension dépendant d'une fréquence complexe dans un état passif de l'éolienne (14, 15), dans lequel l'éolienne (14, 15) n'alimente, par le biais du circuit de puissance (23, 24, 25, 29), le réseau de raccordement (16) avec aucun courant électrique, et un module calculateur (30) qui est conçu pour déterminer une valeur de précharge du réseau à partir de la mesure de tension (28) dépendant d'une fréquence complexe et d'une impédance ($Z_{ges}$) dépendant d'une fréquence complexe du circuit de puissance (23, 24, 25, 29) de l'éolienne (14, 15), dans lequel la valeur de précharge du réseau correspond à la fraction d'harmoniques provoquée par le réseau de raccordement (16), et pour déterminer une valeur caractéristique de courant de l'éolienne (14, 15) à partir de la différence entre la mesure de courant (26) dépendant d'une fréquence complexe et la valeur de précharge du réseau.

**Fig. 1**

**Fig. 2**

Fig. 3

Fig. 4

Fig. 5

**Fig. 6**

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1224721 B1

**In der Beschreibung aufgeführte Nicht-Patentliteratur**

- **BADRZADEH et al.** *Power System Harmonic Analysis in Wind Power Plants,* ISBN 978-1-4673-0332-3

- **MORALES et al.** *Assessment of Wind Power Quality: Implementation of IEC61400-21 Procedures, www.icrepq.com/full-paper-icrep/333_MORALES.pdf*